(19)

**Europäisches Patentamt**
**European Patent Office**
**Office européen des brevets**

(11) **EP 4 506 706 A1**

(12) **EUROPEAN PATENT APPLICATION**

(43) Date of publication:
**12.02.2025  Bulletin 2025/07**

(21) Application number: **23306366.8**

(22) Date of filing: **11.08.2023**

(51) International Patent Classification (IPC):
**G01R 31/64** (2020.01)     **G01R 21/06** (2006.01)
**G01R 21/133** (2006.01)     **G01R 25/00** (2006.01)

(52) Cooperative Patent Classification (CPC):
**G01R 25/005; G01R 21/002; G01R 21/06;
G01R 21/1331; G01R 31/64**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **SCHNEIDER ELECTRIC INDUSTRIES SAS
  92500 Rueil-Malmaison (FR)**
• **UNIVERSITE CLAUDE BERNARD - LYON 1
  69100 Villeurbanne (FR)**
• **Centre National de la Recherche Scientifique
  75016 Paris (FR)**
• **Institut National des Sciences Appliquees
  de Lyon (Insa Lyon)
  69100 Villeurbanne (FR)**
• **Ecole Centrale de Lyon
  69131 Ecully Cedex (FR)**

(72) Inventors:
• **Rochefort, Claire
  56680 Plouhinec (FR)**
• **Mitova, Radoslava
  38240 Meylan (FR)**
• **Wang, Miao-xin
  38330 Montbonnot-St-Martin (FR)**
• **Venet, Pascal
  69100 Villeurbanne (FR)**
• **Clerc, Guy
  69890 La Tour-de-Salvagny (FR)**
• **Sari, Ali
  69100 Villeurbanne (FR)**
• **Kremer, Philippe
  38420 Le Versoud (FR)**

(74) Representative: **Plasseraud IP
  104 Rue de Richelieu
  CS92104
  75080 Paris Cedex 02 (FR)**

(54) **DETECTION OF THERMAL RUNAWAY IN FILM CAPACITORS**

(57)     A method of detecting the onset of thermal runaway of a film capacitor (Cp) used in an AC application by monitoring at least one of the following indicators: the phase difference φ(t) between the electric voltage across the film capacitor (Cp) and the electric current flowing through the film capacitor (Cp), the slope dφ(t)/dt of said phase difference φ(t), the active power P(t) of the film capacitor (Cp), and/or the slope dP(t)/dt of said active power P(t).

FIG. 8

EP 4 506 706 A1

## Description

## Technical Field

This disclosure generally pertains to the field of electric power conversion and electric power converters. More specifically, it may relate to power converters in motor drives, in uninterruptible power supplies and in photovoltaic installations. Typically, these electrical devices include capacitors, such as film capacitors. The present disclosure discusses systems and methods for monitoring the health of film capacitors in power conversion applications.

## Background Art

Document WO 2017/071754 A1 describes several ways of sensing the failure of a capacitor in a High Voltage Direct Current converter. In one technique described from page 22, line 30 to page 24, line 38, measurements of the current flowing through the capacitor and of the voltage across the capacitor are used to estimate the capacitor's power loss. If the estimated power loss deviates from zero by more than a relatively small value, the capacitor is considered to be faulty.

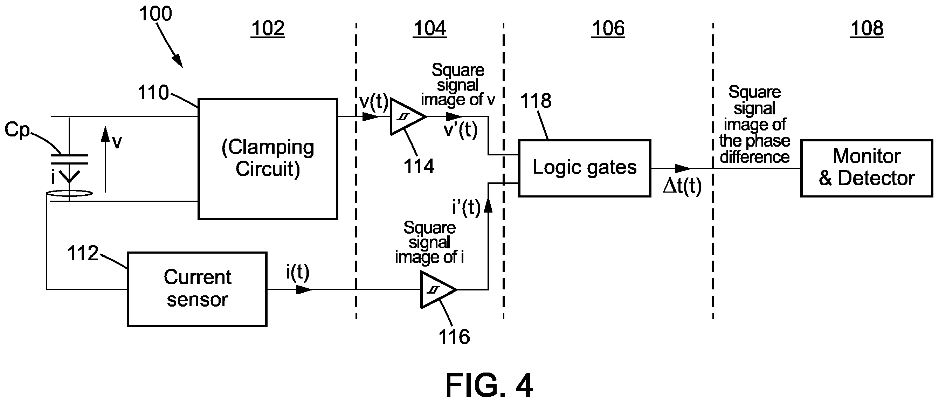

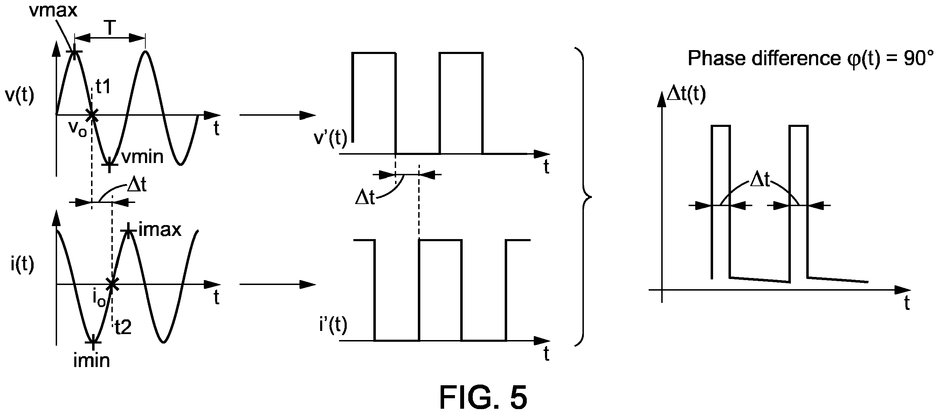

Document EP 2 919 024 A1 presents a method and device for detecting a degraded capacitor in the Y-connected filter capacitor bank of an electric motor drive 10, cf. Figs. 4 and 5. In this known method and device, a capacitor is identified as degraded if the difference between the capacitor's measured and nominal power values is above a predetermined threshold.

A drawback of the techniques known from the above-cited documents is that they are apparently designed to sense various kinds of failures in all kinds of capacitors. Accordingly, they are not specifically suited to the detection of thermal runaway in film capacitors. Furthermore, these known techniques require knowledge of the value of the nominal capacitance of the monitored capacitor. This parameter is not always readily available.

## Summary

In view of the above, it is an object of the present disclosure to provide a method allowing the reliable and early detection of thermal runaway in a film capacitor used in an AC application. Preferably, this method should require little or no knowledge of the characteristics of the corresponding film capacitor.

According to the present disclosure, this object is achieved with a method of detecting the onset of thermal runaway of a film capacitor used in an AC application by monitoring at least one of the following indicators: the phase difference $\varphi(t)$ between the electric voltage across the film capacitor and the electric current flowing through the film capacitor, the slope $d\varphi(t)/dt$ of said phase difference $\varphi(t)$, the active power $P(t)$ of the film capacitor, and/or the slope $dP(t)/dt$ of said active power $P(t)$.

Indeed, the present inventors have found out that the active power $P(t)$ of a film capacitor and the phase shift $\varphi(t)$ between its current and voltage are good indicators of a thermal runaway of the film capacitor. Experiments show that each of these two indicators reacts quickly at the onset of a thermal runaway. To the knowledge of the inventors, the monitoring of the phase difference and/or of the active power is a novel and innovative approach unknown from the prior art. Furthermore, the two indicators can be easily determined from the capacitor's voltage and current signals, independently of the capacitor's specific characteristics.

The following features can be optionally implemented, separately or in combination with each other:

- the monitoring of the least one indicator involves the monitoring of the electric voltage $v(t)$ across the film capacitor and of the electric current $i(t)$ flowing through the film capacitor;

- the method comprises the following steps: continuously determining a first time instant $t1$ at which the electric voltage $v(t)$ across the film capacitor has a predetermined reference voltage value $v0$; continuously determining a second time instant $t2$ at which the electric current $i(t)$ flowing through the film capacitor has a predetermined reference current value $i0$ related to the predetermined reference voltage value $v0$; based on each determined first time instant $t1$ and determined second time instant $t2$, continuously determining the current phase difference $\varphi(t1, t2)$ between the electric voltage $v(t)$ and the electric current $i(t)$ of the film capacitor to thereby obtain a time-varying signal $\varphi(t)$ of the phase difference; monitoring the obtained phase difference signal $\varphi(t)$; and detecting the onset of thermal runaway if the value of the monitored phase difference signal $\varphi(t)$ decreases below a predetermined phase difference threshold $\varphi th$;

- said predetermined reference voltage value $v0$ is a zero-crossing on a fixed rising edge or falling edge of the electric voltage $v(t)$ and said related predetermined reference current value $i0$ is a zero-crossing on a fixed rising edge or falling edge of the electric current $i(t)$;

- the method comprises the following steps: obtaining a time-varying signal $i(t)$ of the electric current flowing through the film capacitor; obtaining a time-varying signal $v(t)$ of the electric voltage across the film capacitor; based on the obtained time-varying signals $i(t)$ and $v(t)$, determining the active power $P(t)$ of the film capacitor; monitoring the determined active power $P(t)$; and detecting the onset of thermal runaway if the monitored active power $P(t)$ increases above a predetermined active power threshold Pth;

- the value of the predetermined active power threshold Pth is chosen in the range of about 3.5% to about 35% of the apparent power S of the film capacitor;

- the method comprises the further steps of: determining the phase difference $\varphi(t)$ based on the determined active power $P(t)$; monitoring the determined phase difference $\varphi(t)$; and detecting the onset of thermal runaway if the value of the monitored phase difference $\varphi(t)$ decreases below a predetermined phase difference threshold $\varphi$th;

- the value of the predetermined phase difference threshold $\varphi$th is chosen in the range of about 70° to about 88°;

- the method comprises the following steps: obtaining said phase difference $\varphi(t)$; continuously determining, over a predetermined time interval, a representation of the current slope of the phase difference $\varphi(t)$, in particular using a moving average or a linear regression, thus obtaining a time-varying signal dcp(t)/dt of the phase difference slope; monitoring the obtained phase difference slope signal dcp(t)/dt; and detecting the onset of thermal runaway if the monitored phase difference slope signal dcp(t)/dt decreases below a predetermined phase difference slope threshold $M\varphi_{th}$, such as -1°/s;

- the method comprises the following steps: obtaining said active power $P(t)$; continuously determining, over a predetermined time interval, a representation of the current slope of the active power $P(t)$, in particular using a moving average or a linear regression, thus obtaining a time-varying signal dP(t)/dt of the active power slope; monitoring the obtained active power slope signal dP(t)/dt; and detecting the onset of thermal runaway if the monitored active power slope signal dP(t)/dt increases above a predetermined active power slope threshold $Mp_{th}$, such as 1.5 % of S/s, where S is the apparent power of the film capacitor;

- the method comprises the following steps: generating a time-varying state vector having at least two components and representing the capacitor's operational state as a function of time, each component of the state vector corresponding to one of said indicators; monitoring the generated state vector using a classification algorithm, which takes the generated state vector as an input, wherein the classification algorithm continuously checks whether the generated state vector belongs to a predetermined class of state vectors corresponding to a normal operation of the film capacitor; and detecting the onset of thermal runaway if a check of the classification algorithm is negative.

The present disclosure also relates to a signal processing circuit configured to execute a method as defined above. Preferably, the signal processing circuit comprises one or more of the following features:

- an analogue measurement stage, a digitization stage, a combination stage, and a monitoring and detection stage;

- the combination stage includes: an optocoupler having, as a light source, an LED and a light sensor, such as a phototransistor, for detecting the light emitted by the LED, the LED being supplied with a driving current i'(t) that is an image of the capacitor current i(t); and a switch, such as a transistor, connected in series with the LED, the opening and closing of the switch being controlled by the capacitor voltage v(t);

- the combination stage includes: an optocoupler having, as a light source, an LED and a light sensor, such as a phototransistor, for detecting the light emitted by the LED, the LED being supplied with a driving voltage corresponding to the capacitor voltage v(t); and a switch, such as a transistor, connected in series with the LED, the opening and closing of the switch being controlled by the capacitor current i(t);

- the digitization stage includes a detection circuit for detecting zero-crossings of the capacitor voltage v(t); the detection circuit receives an input signal corresponding to the capacitor voltage v(t) and outputs a zero-crossing detection signal z(t); the detection circuit comprises an optocoupler having a light source, such as an LED, and a light sensor, such as a phototransistor, for detecting the light emitted by the light source, a switch, such as a transistor, for operating the light source, the switch being connected in series with the light source, and a triggering circuit for triggering the switch, the triggering circuit receiving the input signal; upon a zero-crossing of the input signal, the triggering circuit triggers the switch, which causes the light source to emit a light pulse that is converted into the zero-crossing detection signal by the light sensor;

- the triggering circuit comprises: a trigger capacitor for triggering the switch by discharging; a discharge resistor connected in parallel with the trigger capacitor for discharging the trigger capacitor; a first control diode connected in front of the trigger capacitor and the discharge resistor, the first control diode controlling the charging of the trigger capacitor and its discharging via the discharge resistor; and a second control diode connected in series with the trigger capacitor, the second control diode controlling the triggering of the switch;

- the combination stage includes a logic gate, such as an SR latch, which receives as one input the zero-crossing detection signal z(t) from the detection circuit.

The present disclosure also relates to a computer software comprising instructions to implement a method as defined above when the software is executed by a processor.

The present disclosure also relates to a recording medium on which said computer software is stored.

## Brief Description of the Drawings

The above and other features and advantages of the present disclosure are detailed in the following detailed description and in the corresponding figures, in which:

### Fig. 1

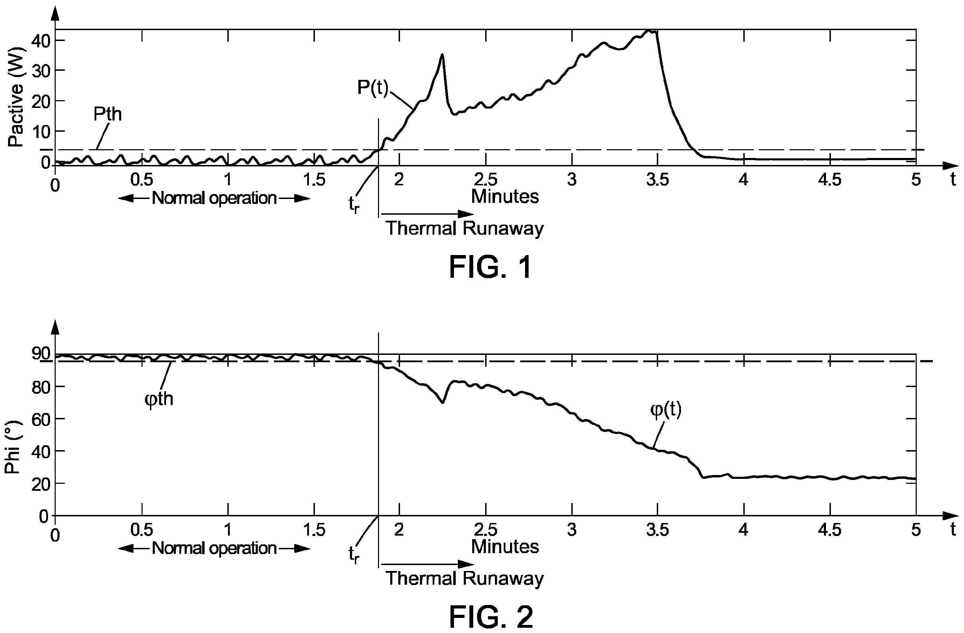

[Fig. 1] is a plot, as a function of time, of the active power P(t) of a film capacitor undergoing thermal runaway.

### Fig. 2

[Fig. 2] is a plot, as a function of time, of the phase difference $\varphi(t)$ between the voltage and the current of the same film capacitor as in Fig. 1.

### Fig. 3

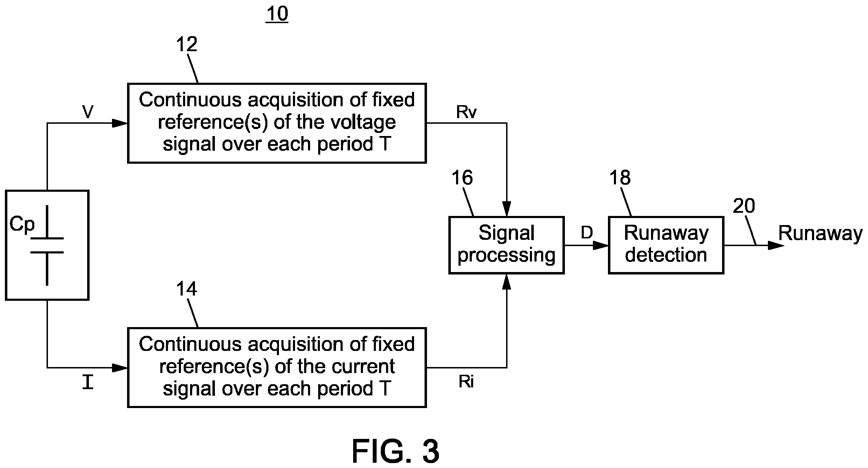

[Fig. 3] is a generic block diagram illustrating the principles of the present disclosure.

### Fig. 4

[Fig. 4] is a circuit diagram showing a signal processing circuit according to a first embodiment of the present disclosure connected to a film power capacitor for monitoring the film power capacitor.

### Fig. 5

[Fig. 5] shows the voltage and the current of the film power capacitor of Fig. 4 as a function of time, and the signal processing done by the signal processing circuit of Fig. 4 based on the voltage and the current.

### Fig. 6

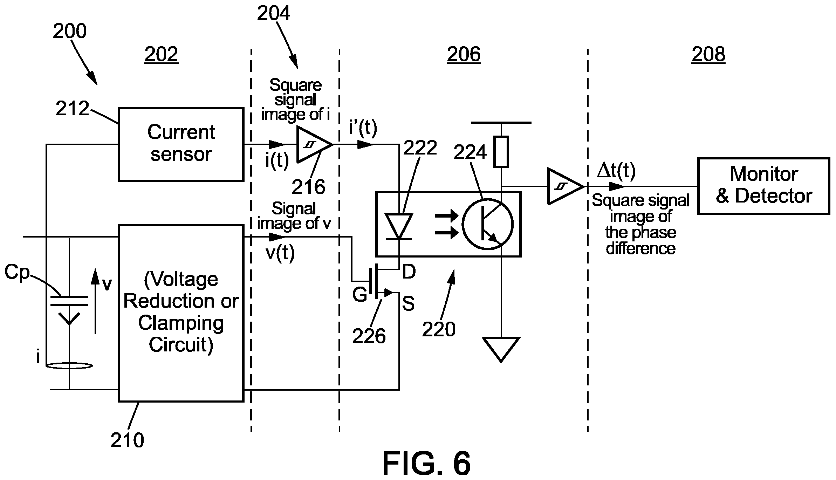

[Fig. 6] is a circuit diagram showing a signal processing circuit according to a second embodiment of the present disclosure connected to a film power capacitor for monitoring the film power capacitor.

### Fig. 7

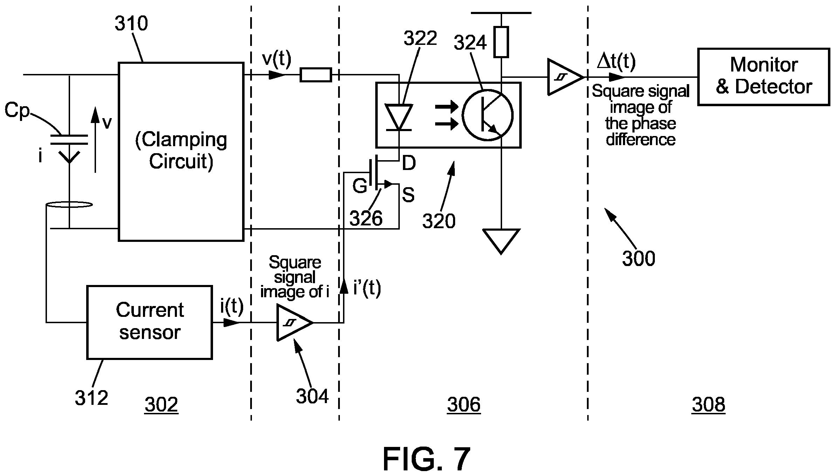

[Fig. 7] is a circuit diagram showing a signal processing circuit according to a third embodiment of the present disclosure connected to a film power capacitor for monitoring the film power capacitor.

### Fig. 8

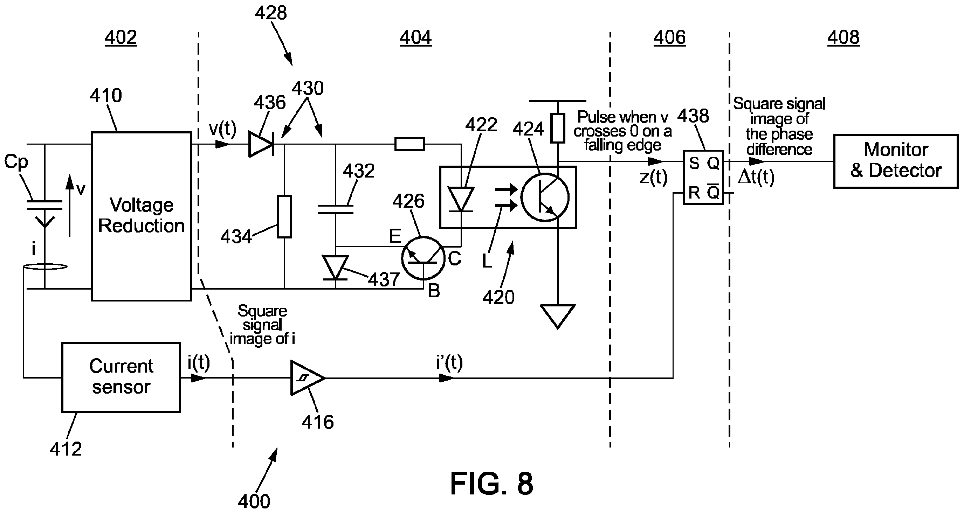

[Fig. 8] is a circuit diagram showing a signal processing circuit according to a fourth embodiment of the present disclosure connected to a film power capacitor for monitoring the film power capacitor.

### Fig. 9

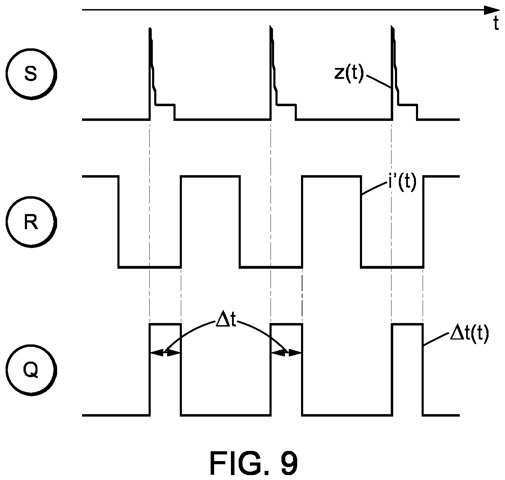

[Fig. 9] is an example of the two input signals S and R of the logic gate of the signal processing circuit of Fig. 8, and of the resulting output signal Q.

### Fig. 10

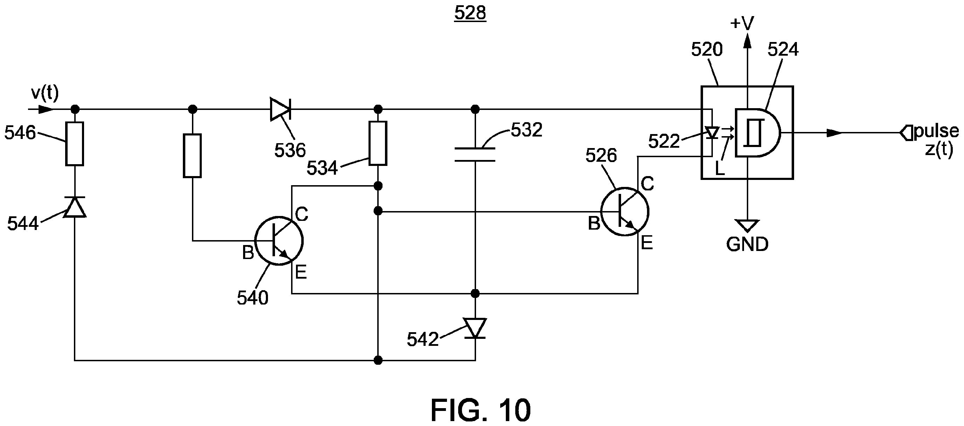

[Fig. 10] is a circuit diagram showing a detection circuit variant that may be alternatively implemented in the signal processing circuit of Fig. 8.

## Description of Embodiments

### Definitions

The present disclosure deals with film capacitors. There are two types of film capacitors: film/foil capacitors and metallized film capacitors.

A film/foil capacitor is typically made of dielectric films layered with thin metal foils.

A metallized film capacitor is typically made of dielectric films having a metallic coating on their surface.

In typical film capacitors, the dielectric films are rolled together into a preferably cylindrical winding. A terminal is attached to each end of the winding. The winding may be potted into a casing and/or covered by a protective coating. A common material for the dielectric films is polypropylene. A common material for the metal foils or metallic coating is aluminium, zinc, or a combination of zinc and aluminium.

During their operation, film capacitors may fail in different ways. The present disclosure focuses on one particular type of capacitor failure, known as thermal runaway. Thermal runaway is a catastrophic failure. In a thermal runaway, the film capacitor heats up uncontrollably. The corresponding increase in temperature leads to a self-reinforcing melting of the capacitor's dielectric. This phenomenon is often accompanied by the release of inflammable gas. The outcome of a thermal runaway is the disintegration of the film capacitor. Sometimes, the film capacitor may explode or burn, which is particularly dangerous. The inventors' research suggests that a thermal runaway is either caused by excessive resistive losses in the capacitor, or by an enduring short-circuit in the form of an electric arc across a dielectric film of the capacitor.

In the context of the present disclosure, the active power P of a film capacitor operating under steady-state periodic conditions is defined as the mean value, taken over n periods T, of the capacitor's instantaneous power $p$, where $n \in \mathbb{N}^*$. The active power P may be defined by the following equation:

$$P = \frac{1}{nT} \int_0^{nT} p(t)dt \qquad (1)$$

The instantaneous power *p* of an operating film capacitor is defined as the product of the instantaneous electric voltage *v(t)* across the film capacitor and the instantaneous electric current *i(t)* flowing through the film capacitor. The instantaneous power *p* may be defined by the following equation:

$$p(t) = v(t) \times i(t) \qquad (2)$$

The apparent power S of a film capacitor is defined as the product of the root mean square voltage Vrms across the capacitor and the root mean square current Irms flowing through the capacitor. The apparent power S may be defined by the following equation:

$$S = \text{Vrms} \times \text{Irms} \qquad (3)$$

In the context of the present disclosure, the phase difference $\varphi(t)$ between the electric voltage and the electric current of a film capacitor at the time instant t is defined by the following equation:

$$\varphi(t) = \Phi_v(t) - \Phi_i(t) \qquad (4),$$

where $\Phi_v(t)$ is the phase angle in degrees (°) of the electric voltage at time instant t, and $\Phi_i(t)$ is the phase angle in degrees (°) of the electric current at time instant t.
In the present disclosure, the electric current is taken as the reference, i.e., as the origin, for the determination of a phase angle. In other words, phase angles are determined relative to the electric current.

*Detailed description*

Referring now to figures 1 and 2, we will discuss the two main indicators, which are used in the present disclosure to detect the onset of thermal runaway in a monitored film capacitor. The two indicators are the active power P of the monitored film capacitor and the phase difference $\varphi$ between the voltage and the current of the monitored film capacitor.
Figures 1 and 2 are graphs showing the evolution as a function of time t of these two indicators for a film capacitor experiencing thermal runaway. Figure 1 shows the capacitor's active power P as a function of time t. Figure 2 shows the capacitor's phase difference $\varphi$ as a function of time t. The thermal runaway of the film capacitor starts at an instant, which is identified as $t_r$ in the two graphs. As apparent from the two graphs, the phase

difference $\varphi$ and the active power P are very sensitive to a thermal runaway. As can be seen from figure 1, as soon as the thermal runaway starts, the active power P increases rapidly from its normal operating value of around 0 W. Likewise, see figure 2, as soon as the capacitor undergoes thermal runaway, the phase difference $\varphi$ decreases rapidly from its expected operating value of around 90°. Accordingly, by monitoring the phase difference $\varphi$ and/or the active power P, one can reliably and quickly detect a capacitor's thermal runaway.
The active power P and the phase difference $\varphi$ are particularly well suited for the detection of a thermal runaway. This is because, as shown in figures 1 and 2, these two indicators react quickly and strongly to a thermal runaway. Furthermore, this reaction is specific to thermal runaways. To the knowledge of the inventors, other types of capacitor failures do not lead to a comparable behaviour of the capacitor's active power and phase difference. By monitoring the phase difference and/or the active power, it is thus possible to single out a thermal runaway from other types of capacitor failures.
Experiments have shown that, in a thermal runaway, on average, there is a change in phase difference of at least about 1° per second, and an increase in active power P of at least about 1.5% of the apparent power S per second. In contrast thereto, under normal capacitor ageing, such a change takes at least 100 hours. The order of magnitude difference is $10^5$. A noticeable and continued change in the phase difference $\varphi$ and/or the active power P within a few seconds is thus a clear indication of a thermal runaway instead of normal ageing of the capacitor.
In the following detailed description of embodiments illustrated by Figs. 3 to 10, the monitored film capacitor Cp is assumed to be part of a power conversion device. Accordingly, in the following, the film capacitor Cp will be called a film power capacitor since it is used in a power conversion application. However, the principles of the present disclosure may also apply to the monitoring of film capacitors in other than power conversion applications.
The film power capacitor Cp can be an individual capacitor, i.e., an individual electric component. Alternatively, Cp can be an equivalent capacitor, which stands for a whole bank of electrically connected capacitors.
With reference to figure 3, there is shown a block diagram illustrating the general process, according to the present disclosure, of detecting the onset of thermal runaway of a film power capacitor Cp.
The general process 10 of figure 3 involves the continuous acquisition of one or more fixed references of the capacitor's voltage signal V over each period T of the voltage signal V, cf. block 12. The result is a voltage reference signal Rv corresponding to the acquired voltage reference(s).
General process 10 also involves the continuous acquisition of one or more fixed references of the capacitor's current signal I over each period T of the current signal I, cf. block 14. The result is a current reference signal Ri corresponding to the acquired current reference(s).

The signals Rv, Ri are then processed to obtain a detection signal D, cf. block 16. Detection signal D may for example correspond to the active power curve P(t) illustrated in figure 1, or to the phase difference curve φ(t) illustrated in figure 2.

Detection signal D is then monitored to detect the onset of a thermal runaway of film power capacitor Cp, cf. block 18. If a runaway is detected, a warning may be issued or corrective measures may be taken, cf. arrow 20.

Turning now to figure 4, we will describe a first embodiment 100 of a signal processing circuit for detecting the onset of thermal runaway of a film power capacitor according to the present disclosure.

This first signal processing circuit embodiment 100 may be used to monitor a film power capacitor Cp. The individual or equivalent film power capacitor Cp may be part of a power converter.

The signal processing circuit 100 comprises an analogue measurement stage 102, a digitization stage 104, a combination stage 106 and a monitoring and detection stage 108. The measurement stage 102 includes a voltage sensor 110 and a current sensor 112. The voltage sensor 110 is used to measure the voltage v across the capacitor Cp. The current sensor 112 is used to measure the current i flowing through the capacitor Cp.

The digitization stage 104 includes two Schmitt triggers 114 and 116. Each Schmitt trigger 114, 116 may provide galvanic isolation. The first Schmitt trigger 114 converts the analogue voltage signal v(t) provided by the voltage sensor 110 into a digital binary signal v'(t). The second Schmitt trigger 116 converts the analogue current signal i(t) provided by the current sensor 112 into a digital binary signal i'(t). The two binary signals v'(t) and i'(t) are combined in the combination stage 106. Here, the combination stage 106 includes one or more logic gates 118. The output Δt(t) of the combination stage 106 is monitored by the monitoring and detection stage 108.

The input and output signals of the signal processing circuit 100 are illustrated in figure 5. The left-hand side shows the capacitor's voltage v(t) and current i(t) as measured by the voltage sensor 110 and the current sensor 112. Figure 5 shows the capacitor's voltage and current signals under normal operating conditions. When the capacitor Cp operates normally, and as shown in figure 5, the voltage signal and the current signal are out of phase by 90°. This is also apparent from the phase difference curve φ(t) in figure 2. The curve φ(t) is stable at around 90° until the start of the thermal runaway at the instant $t_r$.

As shown in the middle of figure 5, the analogue voltage signal v(t) is converted into a digital binary signal v'(t) by the first Schmitt trigger 114, and the analogue current signal i(t) is converted into a digital binary signal i'(t) by the second Schmitt trigger 116. The binary voltage signal v'(t) is high when the capacitor voltage is positive and is low when the capacitor voltage is negative. The binary voltage signal v'(t) is thus a square signal, which is an image of the analogue voltage signal v(t). The binary current signal i'(t) is high when the capacitor current is positive and low when the capacitor current is negative. Hence, the binary signal i'(t) is a square signal, which is an image of the analogue current signal i(t).

The two binary signals v'(t) and i'(t) are fed into the logic gates 118. The logic gates 118 compare the two binary signals v'(t) and i'(t). The logic gates 118 then output a signal Δt(t).

In the example shown in figure 4, Δt(t) indicates the duration of the time intervals Δt in which both the capacitor voltage and the capacitor current are negative. Example time intervals Δt are identified in figure 5. The signal Δt(t) output by the logic gates 118 is shown on the right-hand side of figure 5. It is a square signal, which reflects the phase difference between the capacitor voltage v(t) and the capacitor current i(t).

We will now describe a method according to the present disclosure that is carried out by the signal processing circuit 100 to detect the onset of a thermal runaway of the film power capacitor Cp.

In one step, the current sensor 112 obtains the time-varying signal i(t) of the electric current flowing through the film power capacitor Cp.

In another step, the voltage sensor 110 obtains the time-varying signal v(t) of the electrical voltage across the film power capacitor Cp.

In a further step, based on the obtained time-varying signals i(t) and v(t), the signal processing circuit 100 determines the phase difference φ(t) between v(t) and i(t). This step is executed by the digitization stage 104 and the combination stage 106.

In a further step, the determined phase difference is monitored. The onset of a runaway is detected if the value of the monitored phase difference decreases below a predetermined phase difference threshold φth. This step is carried out by the monitoring and detection stage 108.

In the example shown in figures 4 and 5, the determination of the phase difference amounts to the generation of the square signal Δt(t), which is output by the logic gates 118. Indeed, each time interval Δt, which is the timespan in which both the capacitor voltage and the capacitor current are negative, is an adequate representation of the current phase difference φ(t) since both are linked via the following equation:

$$\varphi = 180 - (\Delta t \times 360/T) \qquad (5),$$

where the unit of the phase difference φ is degrees (°). In this equation, T is the period of the voltage and current signals, cf. figure 5. In a power conversion application where the monitored film power capacitor Cp operates under the standard European mains frequency of 50 Hz, T will be 1/50 s.

Accordingly, monitoring the signal Δt(t) shown on the right-hand side of figure 5 amounts to monitoring the phase difference φ(t).

The conversion of Δt(t) into φ(t) using the above equation (5) is done by the monitoring and detection stage 108 to allow the comparison with the predetermined phase difference threshold φth. An example of this threshold φth is shown in the graph of figure 2. Preferably, the value of the predetermined phase difference threshold φth is chosen in the range of about 70° to about 88°. A preferred value in this range is 85°. Fixing the threshold φth at a value somewhere between 88° and 90° is possible but is likely to lead to false positives in the detection.

In the example shown in figures 4 and 5, the phase difference φ(t) is determined based on the timespan where both the capacitor voltage and the capacitor current are negative. However, the present disclosure is not limited thereto. More generally, the phase difference φ(t) may be determined based on the time interval between a first reference point v0 in the time-varying voltage signal v(t) and a corresponding second reference point i0 in the time-varying current signal i(t). The first reference point v0 may be a zero-crossing on a fixed rising edge or falling edge of the voltage signal v(t), and said second reference point i0 may be a zero-crossing on a fixed rising edge or falling edge of the current signal i(t). It is to be noted that equation (5) above may have to be adapted depending on the time interval that is chosen for the determination of the phase difference.

Furthermore, in the example shown in figures 4 and 5, a single reference point pair (v0, i0) is taken for each period T of the voltage and current signals. Again, the present disclosure is not limited thereto. It is equally possible to take several reference point pairs (v0, i0), (vmax, imax), (vmin, imin), etc. for each period T, and to determine the phase difference φ(t) based on this plurality of reference point pairs.

In the first embodiment described above, the onset of thermal runaway is detected based on the monitoring of the phase difference between the capacitor voltage and the capacitor current. However, alternatively or additionally, the onset of a runaway may be detected based on the monitoring of the active power P(t) of the film power capacitor. Indeed, as exemplified by figure 1, the active power P(t) is also a good indicator of thermal runaway. The active power may be determined from the time-varying signals i(t) and v(t) using equations (1) and (2) above. The onset of a runaway is detected if the monitored active power P(t) increases above a predetermined active power threshold Pth. Preferably, the value of the predetermined active power threshold Pth is chosen in the range of about 3.5% to about 35% of the apparent power S of the monitored film power capacitor. A preferred value in this range is 7%. An exemplary active power threshold Pth is shown in figure 1.

In another variant, the phase difference φ(t) may be determined based on the determined active power P(t). This may be done using the following equation:

$$\varphi = \arccos(P/S) \qquad (6)$$

where P is the active power of the film power capacitor and S is the apparent power of the film power capacitor.

In this variant, the active power P(t) is determined from the capacitor voltage and capacitor current, and then the phase difference φ(t) is determined from the active power using equation (6).

In a further variant, it is also possible to detect the onset of thermal runaway by monitoring the time derivative dcp(t)/dt of the phase difference φ(t) and/or the time derivative dP(t)/dt of the active power P(t). In other words, instead of looking at the phase difference signal or the active power signal itself, one may look at the slope of the signal. As apparent from figures 1 and 2, a substantial and continuing slope in φ(t) and/or P(t) may also be an indication of thermal runaway. It is also possible to combine the monitoring of the signal and the monitoring of the slope of the signal.

The slope of the signal may for example be determined using a linear regression or a moving average. The slope determination may also involve the prior reduction of noise in the phase difference signal/active power signal.

When monitoring the slope of the phase difference φ(t), one may detect the onset of thermal runaway if the slope decreases below a predetermined threshold $M\varphi_{th}$. Experiments have shown that a drop in the phase difference of 1° per second or more is generally a clear indicator of a thermal runaway. Of course, a different threshold may apply, depending on the specific application.

When monitoring the slope of the active power P(t), one may detect the onset of thermal runaway if the slope increases above a predetermined threshold $Mp_{th}$. Experiments have shown that a rise in the active power of 1.5% of the apparent power S per second or more is generally a clear indicator of a thermal runaway. Of course, a different threshold may apply, depending on the specific application.

Turning to figure 6, we will now describe a second embodiment 200 of a signal processing circuit according to the present disclosure. The signal processing circuit 200 comprises an analogue measurement stage 202, a digitization stage 204, a combination stage 206 and a monitoring and detection stage 208. The combination stage 206 includes an optocoupler 220 having, as a light source, an LED 222 and a light sensor 224, such as a phototransistor, for detecting the light emitted by the LED 222, the LED 222 being supplied with a driving current i'(t) that is an image of the capacitor current i(t).

The combination stage 206 also includes a switch 226, such as a transistor, connected in series with the LED 222, the opening and closing of the switch 226 being controlled by the capacitor voltage v(t).

In the signal processing circuit 200 of figure 6, the current signal i(t) and the voltage signal v(t) of the film power capacitor Cp are combined in the combination stage 206 to obtain a square signal Δt(t), which is an image of the phase difference φ(t). Here, Δt(t) is a series of square pulses whose widths correspond to the time intervals where both the capacitor current i(t) and the capacitor voltage v(t) are positive. The signal Δt(t) mirrors the time intervals where the LED 222 of the optocoupler 220 emits light. Indeed, the LED 222 only emits light when the current i(t) flows in the right direction, i.e., is positive, and when the capacitor voltage v(t) is positive. This is because the transistor switch 226 is closed and thus allows current flow through the LED 222 only when the voltage v(t) is positive. To achieve this, the capacitor voltage v(t) is fed to the gate G of the transistor switch 226.

The optocoupler 220 ensures galvanic isolation between, on the one hand, the measurement stage 202 and the digitization stage 204, and, on the other hand, the monitoring and detection stage 208.

Turning to figure 7, there is illustrated a third embodiment 300 of a signal processing circuit according to the present disclosure. The signal processing circuit 300 is a variant of the signal processing circuit 200, where it is the LED 322 that is supplied with the capacitor voltage v(t) as its driving voltage, and it is the gate G of the transistor switch 326 that is provided with a square signal image i'(t) of the capacitor current i(t). Accordingly, in this third embodiment, the opening and closing of the transistor switch 326 is controlled by the capacitor current i(t). Like in the signal processing circuit 200 of figure 6, the square signal image of the phase difference Δt(t) is a series of pulses, whose widths correspond to the time intervals where both the capacitor voltage and the capacitor current are positive.

Turning to figure 8, there is illustrated a fourth embodiment 400 of a signal processing circuit according to the present disclosure. Like the other signal processing circuits 100, 200 and 300, the signal processing circuit 400 comprises an analogue measurement stage 402, a digitization stage 404, a combination stage 406, and a monitoring and detection stage 408. Here, the digitization stage 404 includes a detection circuit 428 for detecting zero-crossings of the capacitor voltage v(t). The detection circuit 428 receives an input corresponding to the capacitor voltage v(t) and outputs a zero-crossing detection signal z(t). The detection circuit 428 comprises an optocoupler 420 having a light source 422, such as an LED, and a light sensor 424, such as a phototransistor, for detecting the light emitted by the light source 422. The detection circuit 428 also comprises a switch 426, such as a transistor, for operating the light source 422, the switch 426 being connected in series with the light source 422. The detection circuit 428 further comprises a triggering circuit 430 for triggering the switch 426, the triggering circuit 430 receiving the input signal corresponding to the capacitor voltage v(t). Upon a zero-crossing of the input signal, i.e., a zero-crossing of the capacitor voltage v(t), the triggering circuit 430 triggers the transistor switch 426, which causes the light source 422 to emit a light pulse L that is converted into the zero-crossing detection signal z(t) by the light sensor 424. In fact, the triggering circuit 430 triggers the transistor switch 426 upon each zero-crossing on a falling edge of the capacitor voltage v(t), but not upon a zero-crossing on a rising edge.

The triggering circuit 430 includes a trigger capacitor 432, a discharge resistor 434, a first control diode 436, and a second control diode 437.

The triggering circuit 430 comprises the trigger capacitor 432 for triggering the transistor switch 426. The transistor switch 426 is triggered, i.e., closes when the trigger capacitor 432 discharges. After the complete discharge of the trigger capacitor 432 or when the second control diode 437 is forward-biased, the transistor switch 426 opens again.

The triggering circuit 430 also comprises the discharge resistor 434 connected in parallel with the trigger capacitor 432 for discharging the trigger capacitor 432.

The triggering circuit 430 further comprises the first control diode 436 connected in front of the trigger capacitor 432 and the discharge resistor 434. The first control diode 436 controls the charging of the trigger capacitor 432 and its discharging via the discharge resistor 434.

The triggering circuit 430 further comprises the second control diode 437 connected in series with the trigger capacitor 432. The second control diode 437 controls the triggering of the switch 426. The voltage across the second control diode 437 is controlled via the first control diode 436 or the trigger capacitor 432.

The combination stage 406 includes a logic gate 438, here an SR latch. The SR latch 438 receives as one input S the zero-crossing detection signal z(t) from the detection circuit 428. The other input R corresponds to the square signal image i'(t) of the capacitor current i(t).

An onset of thermal runaway of the film power capacitor Cp is detected by the signal processing circuit 400 in the following way:

The square signal image i'(t) of the capacitor current i(t) is obtained with the current sensor 412 and the Schmitt trigger 416. This square signal image i'(t) is represented in figure 9. It corresponds to the input R of the SR latch 438. i'(t) is a binary signal, which is high when the capacitor current is positive and low when the capacitor current is negative.

The signal z(t) (which is output by the detection circuit 428 and which indicates the consecutive zero-crossings on a falling edge of the capacitor voltage) is obtained by the switching of the transistor switch 426.

The switching of the transistor switch 426 is controlled by the triggering circuit 430. Because of the control diode 436, the trigger capacitor 432 only charges when the capacitor voltage v(t) is positive. When the voltage across it is too low, the control diode 436 blocks and stops conducting. Consequently, the trigger capacitor 432 discharges via the discharge resistor 434 and triggers the transistor switch 426. The resulting closing of the transistor switch 426 allows the current to flow through the optocoupler's photodiode 422. The corresponding light L emitted by the photodiode 422 is detected by the phototransistor 424. The signal output of the phototransistor 424 corresponds to the zero-crossing detection signal z(t). The photocoupler 420 guarantees the galvanic isolation.

The zero-crossing detection signal z(t) is shown in figure 9. It corresponds to the input S of the SR latch 438. The zero-crossing detection signal z(t) and the square current signal i'(t) are combined in the SR latch. The corresponding output Q (see figure 9) is a square signal image $\Delta t(t)$ of the phase difference between the capacitor voltage and the capacitor current.

The signal $\Delta t(t)$ is processed and monitored by the monitoring and detection stage 408. More precisely, the monitoring and detection stage 408 calculates the actual phase difference $\varphi(t)$ from $\Delta t(t)$ using equation (5) above. If the value of the calculated phase difference $\varphi(t)$ decreases below a predetermined phase threshold $\varphi$th, then the monitoring and detection stage 408 concludes that the monitored film power capacitor Cp undergoes thermal runaway. Preferably, in such a case, the film power capacitor Cp is disconnected to prevent any catastrophic failure.

In the example circuit of figure 8, the logic gate used in the combination stage 406 is an SR latch. However, the present disclosure is not limited to any particular type of logic gate. Referring back to figure 4, examples of logic gates, which may be used as the one or more logic gates 118 in the combination stage 106, are NOT gates, OR gates and AND gates. These logic gates may be implemented using one or more operational amplifiers. Furthermore, the one or more logic gates 118 may not be present as discrete components but may implemented via an integrated circuit such as a Field Programmable Gate Array (FPGA), an Application Specific Integrated Circuit (ASIC) or a microprocessor.

With reference to figure 10, there is shown a variant 528 of the detection circuit 428 of figure 8. This detection circuit 528 has a control transistor 540 and two control diodes 536, 542. Current may flow through transistor switch 526 provided that no more current flows through control transistor 540. Control diodes 536, 542 allow current flow through control transistor 540 and the charging of trigger capacitor 532 only when the capacitor voltage v(t) is positive. When the capacitor voltage v(t) is lower than a predetermined voltage threshold needed for control transistor 540 and control diode 542, then trigger capacitor 532 discharges via the discharge resistor 534.

This allows an inverse voltage across control diode 542, which closes transistor switch 526, so that the trigger capacitor 532 discharges via the LED 522 of the optocoupler 520, which causes the LED 522 to emit a light pulse L. A limiting diode 544 and a limiting resistor 546 limit the voltage across the detection circuit 528 when the capacitor voltage v(t) is negative (there is no current flow through limiting diode 544 when v(t) is positive).

The above-described methods of detecting the onset of thermal runaway of a film power capacitor and the corresponding signal processing circuits have in particular the following advantages:

- The detection can be carried out online and in real time, while the monitored film power capacitor is operating;

- The detection needs little or no information about the specifics of the monitored film power capacitor;

- The detection works without consideration of environmental stress factors;

- By monitoring the active power and/or the phase difference of the film power capacitor, runaway is detected early. Hence, catastrophic failure, such as explosion or fire, can be reliably prevented;

- The detection works without additional intrusive sensors such as temperature sensors;

- The detection can be implemented on a single capacitor or on a bank of capacitors;

- The detection can be applied to a single phase or a three-phase system.

**Claims**

1. A method of detecting the onset of thermal runaway of a film capacitor (Cp) used in an AC application by monitoring at least one of the following indicators:

    - the phase difference $\varphi(t)$ between the electric voltage across the film capacitor (Cp) and the electric current flowing through the film capacitor (Cp);
    - the slope dcp(t)/dt of said phase difference cp(t);
    - the active power P(t) of the film capacitor (Cp); and/or
    - the slope dP(t)/dt of said active power P(t).

2. The method of the preceding claim, wherein the monitoring of the least one indicator involves the monitoring of the electric voltage v(t) across the film capacitor (Cp) and of the electric current i(t) flowing through the film capacitor (Cp).

3. The method of any one of the preceding claims, comprising the following steps:

    a. continuously determining a first time instant t1 at which the electric voltage v(t) across the film capacitor (Cp) has a predetermined reference voltage value v0;
    b. continuously determining a second time instant t2 at which the electric current i(t) flowing through the film capacitor (Cp) has a predetermined reference current value i0 related to the predetermined reference voltage value v0;
    c. based on each determined first time instant t1 and determined second time instant t2, continuously determining the current phase difference $\varphi$(t1, t2) between the electric voltage v(t) and the electric current i(t) of the film capacitor (Cp) to thereby obtain a time-varying signal $\varphi$(t) of the phase difference;
    d. monitoring the obtained phase difference signal $\varphi$(t); and
    e. detecting the onset of thermal runaway if the value of the monitored phase difference signal $\varphi$(t) decreases below a predetermined phase difference threshold $\varphi$th.

4. The method according to claim 3, wherein said predetermined reference voltage value v0 is a zero-crossing on a fixed rising edge or falling edge of the electric voltage v(t) and said related predetermined reference current value i0 is a zero-crossing on a fixed rising edge or falling edge of the electric i(t).

5. The method according to claim 1 or 2, comprising the following steps:

    a. obtaining a time-varying signal i(t) of the electric current flowing through the film capacitor (Cp);
    b. obtaining a time-varying signal v(t) of the electric voltage across the film capacitor (Cp);
    c. based on the obtained time-varying signals i(t) and v(t), determining the active power P(t) of the film capacitor (Cp);
    d. monitoring the determined active power P(t); and
    e. detecting the onset of thermal runaway if the monitored active power P(t) increases above a predetermined active power threshold Pth.

6. The method according to the preceding claim, wherein the value of the predetermined active power threshold Pth is chosen in the range of about 3.5% to about 35% of the apparent power S of the film capacitor (Cp).

7. The method according to claim 5 or 6, comprising the further steps of:

    - determining the phase difference $\varphi$(t) based on the determined active power P(t);
    - monitoring the determined phase difference $\varphi$(t); and
    - detecting the onset of thermal runaway if the value of the monitored phase difference $\varphi$(t) decreases below a predetermined phase difference threshold $\varphi$th.

8. The method according to claim 3, 4 or 7, wherein the value of the predetermined phase difference threshold $\varphi$th is chosen in the range of about 70° to about 88°.

9. The method according to any one of the previous claims, comprising the following steps:

    a. obtaining said phase difference $\varphi$(t);
    b. continuously determining, over a predetermined time interval, a representation of the current slope of the phase difference $\varphi$(t), in particular using a moving average or a linear regression, thus obtaining a time-varying signal dcp(t)/dt of the phase difference slope;
    c. monitoring the obtained phase difference slope signal d$\varphi$(t)/dt; and
    d. detecting the onset of thermal runaway if the monitored phase difference slope signal dcp(t)/dt decreases below a predetermined phase difference slope threshold M$\varphi_{th}$, such as -1°/s.

10. The method according to any one of the previous claims, comprising the following steps:

    a. obtaining said active power P(t);
    b. continuously determining, over a predetermined time interval, a representation of the current slope of the active power P(t), in particular using a moving average or a linear regression, thus obtaining a time-varying signal dP(t)/dt of the active power slope;
    c. monitoring the obtained active power slope signal dP(t)/dt; and
    d. detecting the onset of thermal runaway if the monitored active power slope signal dP(t)/dt increases above a predetermined active power slope threshold Mp$_{th}$, such as 1.5 % of S/s, where S is the apparent power of the film capacitor (Cp).

11. The method according to claim 1, comprising the following steps:

    a. generating a time-varying state vector having at least two components and representing the capacitor's operational state as a function of time, each component of the state vector corresponding to one of said indicators;

b. monitoring the generated state vector using a classification algorithm, which takes the generated state vector as an input, wherein the classification algorithm continuously checks whether the generated state vector belongs to a predetermined class of state vectors corresponding to a normal operation of the film capacitor; and

c. detecting the onset of thermal runaway if a check of the classification algorithm is negative.

12. A signal processing circuit (100, 200, 300, 400) configured to execute the method according to any one of the preceding claims.

13. The signal processing circuit (100, 200, 300, 400) according to the preceding claim, comprising:

   - an analogue measurement stage (102);
   - a digitization stage (104);
   - a combination stage (106); and
   - a monitoring and detection stage (108).

14. The signal processing circuit (200) according to the preceding claim, wherein the combination stage (206) includes:

   - an optocoupler (220) having, as a light source, an LED (222) and a light sensor (224), such as a phototransistor, for detecting the light emitted by the LED (222), the LED (222) being supplied with a driving current i'(t) that is an image of the capacitor current i(t); and
   - a switch (226), such as a transistor, connected in series with the LED (222), the opening and closing of the switch (226) being controlled by the capacitor voltage v(t).

15. The signal processing circuit (300) according to claim 13, wherein the combination stage (306) includes:

   - an optocoupler (320) having, as a light source, an LED (322) and a light sensor (324), such as a phototransistor, for detecting the light emitted by the LED (322), the LED (322) being supplied with a driving voltage corresponding to the capacitor voltage v(t); and
   - a switch (326), such as a transistor, connected in series with the LED (322), the opening and closing of the switch (326) being controlled by the capacitor current i(t).

16. The signal processing circuit (400) according to claim 13, wherein:

   - the digitization stage (404) includes a detection circuit (428) for detecting zero-crossings of the capacitor voltage v(t);
   - the detection circuit (428) receives an input signal corresponding to the capacitor voltage v(t) and outputs a zero-crossing detection signal z(t);
   - the detection circuit (428) comprises:

      • an optocoupler (420) having a light source (422), such as an LED, and a light sensor (424), such as a phototransistor, for detecting the light (L) emitted by the light source (422);
      • a switch (426), such as a transistor, for operating the light source (422), the switch being connected in series with the light source; and
      • a triggering circuit (430) for triggering the switch (426), the triggering circuit receiving the input signal;

   - upon a zero-crossing of the input signal, the triggering circuit (430) triggers the switch (426), which causes the light source (422) to emit a light pulse (L) that is converted into the zero-crossing detection signal by the light sensor (424).

17. The signal processing circuit (400) according to the preceding claim, wherein the triggering circuit (430) comprises:

   - a trigger capacitor (432) for triggering the switch (426) by discharging;
   - a discharge resistor (434) connected in parallel with the trigger capacitor (432) for discharging the trigger capacitor;
   - a first control diode (436) connected in front of the trigger capacitor (432) and the discharge resistor (434), the first control diode (436) controlling the charging of the trigger capacitor (432) and its discharging via the discharge resistor (434); and
   - a second control diode (437) connected in series with the trigger capacitor (432), the second control diode (437) controlling the triggering of the switch (426).

18. The signal processing circuit (400) according to the preceding claim, wherein the combination stage (406) includes a logic gate (438), such as an SR latch, which receives as one input the zero-crossing detection signal z(t) from the detection circuit (428).

19. A computer software comprising instructions to implement the method according to one of claims 1 to 11 when the software is executed by a processor.

20. A computer-readable non-transient recording medium on which the computer software according to the previous claim is stored.

**FIG. 1**

**FIG. 2**

EP 4 506 706 A1

<u>10</u>

12

Continuous acquisition of fixed
reference(s) of the voltage
signal over each period T

Cp

Rv

16

Signal
processing

D

18

Runaway
detection

20

Runaway

14

Continuous acquisition of fixed
reference(s) of the current
signal over each period T

Ri

V

I

FIG. 3

FIG. 4

FIG. 5

**FIG. 6**

EP 4 506 706 A1

**FIG. 7**

EP 4 506 706 A1

FIG. 8

FIG. 9

FIG. 10

EP 4 506 706 A1

Europäisches
Patentamt

European
Patent Office

Office européen
des brevets

## EUROPEAN SEARCH REPORT

Application Number

EP 23 30 6366

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2010 049102 A1 (DAIMLER AG [DE]) 9 June 2011 (2011-06-09) * paragraph [0003] * * paragraph [0043] – paragraph [0062] * ----- | 1-20 | INV. G01R31/64 G01R21/06 G01R21/133 G01R25/00 |
| X | US 2013/286692 A1 (PATEL YOGESH POPATLAL [US] ET AL) 31 October 2013 (2013-10-31) * paragraph [0044] – paragraph [0045] * * figures 7,11 * ----- | 1-20 | |

TECHNICAL FIELDS
SEARCHED      (IPC)

G01R

The present search report has been drawn up for all claims

| Place of search | Date of completion of the search | Examiner |
|---|---|---|
| Munich | 17 January 2024 | Sedlmaier, Stefan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.............................................................................
& : member of the same patent family, corresponding
document

EPO FORM 1503 03.82 (P04C01)

## EP 4 506 706 A1

### ANNEX TO THE EUROPEAN SEARCH REPORT
### ON EUROPEAN PATENT APPLICATION NO.

EP 23 30 6366

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2024

| Patent document cited in search report | Publication date | Patent family member(s) | Publication date |
|---|---|---|---|
| DE 102010049102 A1 | 09-06-2011 | NONE | |
| US 2013286692 A1 | 31-10-2013 | BR 102013010701 A2 | 25-06-2019 |
| | | CA 2814329 A1 | 30-10-2013 |
| | | CN 103378741 A | 30-10-2013 |
| | | EP 2660962 A2 | 06-11-2013 |
| | | US 2013286692 A1 | 31-10-2013 |

For more details about this annex : see Official Journal of the European Patent Office, No. 12/82

**REFERENCES CITED IN THE DESCRIPTION**

**Patent documents cited in the description**

- WO 2017071754 A1
- EP 2919024 A1